# EUROPEAN PATENT APPLICATION

(11) **EP 4 303 594 A1**
(43) Date of publication of application: **10.01.2024**
(21) Application number: 22763425.0
(22) Date of filing: 04.03.2022
(51) Int. Cl.: G01R 19/00, G01R 31/382

(54) **VOLTAGE MEASUREMENT SYSTEM**

(30) Priority: 05.03.2021 US 202163157251 P; 15.09.2021 US 202163244598 P
(71) Applicant: Nuvoton Technology Corporation Japan, Nagaokakyo City Kyoto 617-8520 (JP)
(72) Inventor: OGUE, Fumiaki, Nagaokakyo City, Kyoto 617-8520 (JP); HATANI, Naohisa, Nagaokakyo City, Kyoto 617-8520 (JP); MORI, Goro, Nagaokakyo City, Kyoto 617-8520 (JP)
(74) Representative: Novagraaf International SA
(86) International application number: PCT/JP2022/009390
(87) International publication number: WO 2022/186375

(57) **Abstract**

A voltage measurement system (10) includes: a first reference signal transmission device (communication device 30) including a first master oscillator (36) that generates a first master clock signal and a first reference signal generation circuit (33) that generates a first reference signal based on the first master clock signal; and a first voltage measurement device (40) including a first slave oscillator (46), a first correction circuit (43) that corrects an oscillation frequency of the first slave oscillator (46) based on the first reference signal, and a first voltage measurement circuit (48). The voltage measurement system (10) includes: a normal mode in which a command signal is transmitted and received between the first reference signal transmission device (communication device 30) and the first voltage measurement device (40); and a correction mode in which the first reference signal is transmitted from the first reference signal transmission device (communication device 30) to the first voltage measurement device (40), and the oscillation frequency of the first slave oscillator (46) is synchronized with an oscillation frequency of the first master oscillator (36) using the first reference signal.

## Description

### [Technical Field]

The present disclosure relates to voltage measurement systems.

### [Background Art]

A conventional voltage measurement system used in a battery module system including a battery module is known (see, for example, Patent Literature (PTL) 1). A battery module includes a plurality of battery cells connected in series. The voltage measurement system includes a plurality of voltage measurement devices and a control device for controlling the plurality of voltage measurement devices. For example, one of the plurality of voltage measurement devices can measure the current flowing through the battery module from the value of voltage applied to a resistor element connected in series to the battery module, and each of the other voltage measurement devices can measure battery cell voltage. This makes it possible to simultaneously measure the voltage of each battery cell and the current flowing through each battery cell.

The voltage and the current of the battery module can vary over time depending on, for example, the state of the load connected to the battery module. Therefore, if the timing of voltage measurement and the timing of current measurement are misaligned, the state of the battery module (charge rate, degradation state, etc.) cannot be determined with high precision. In view of this, conventional voltage measurement systems attempt to align the measurement timing of each voltage measurement device by determining the measurement timing of each voltage measurement device based on the clock signal from the oscillator in each voltage measurement device.

### [Citation List]

### [Patent Literature]

[PTL 1] Japanese Unexamined Patent Application Publication No. 2015-141062

### [Summary of Invention]

### [Technical Problem]

However, the oscillation frequencies of the oscillators in the voltage measurement devices may be misaligned. In such cases, the measurement timing of each voltage measurement device may be misaligned. Therefore, even if measurements are made based on clock signals from the oscillators in the voltage measurement devices, the state of the battery module cannot be determined with high precision.

The present disclosure overcomes such a problem and has an object to provide a voltage measurement system that can control the measurement timing of a voltage measurement device with high precision.

### [Solution to Problem]

In order to overcome the above-described problem, a voltage measurement system according to one aspect of the present disclosure measures a voltage of a battery cell and includes: a first reference signal transmission device including a first master oscillator that generates a first master clock signal and a first reference signal generation circuit that generates a first reference signal based on the first master clock signal; and a first voltage measurement device including a first slave oscillator that generates a first clock signal, a first correction circuit that corrects an oscillation frequency of the first slave oscillator based on the first reference signal, a first voltage measurement circuit, and a first measurement control circuit that controls the first voltage measurement circuit based on the first clock signal. The voltage measurement system includes: a normal mode in which a command signal is transmitted and received between the first reference signal transmission device and the first voltage measurement device; and a correction mode in which the first reference signal is transmitted from the first reference signal transmission device to the first voltage measurement device, and the oscillation frequency of the first slave oscillator is synchronized with an oscillation frequency of the first master oscillator using the first reference signal.

### [Advantageous Effects of Invention]

According to the present disclosure, a voltage measurement system that can control the measurement timing of a voltage measurement device with high precision can be provided.

### [Brief Description of Drawings]

[FIG. 1]

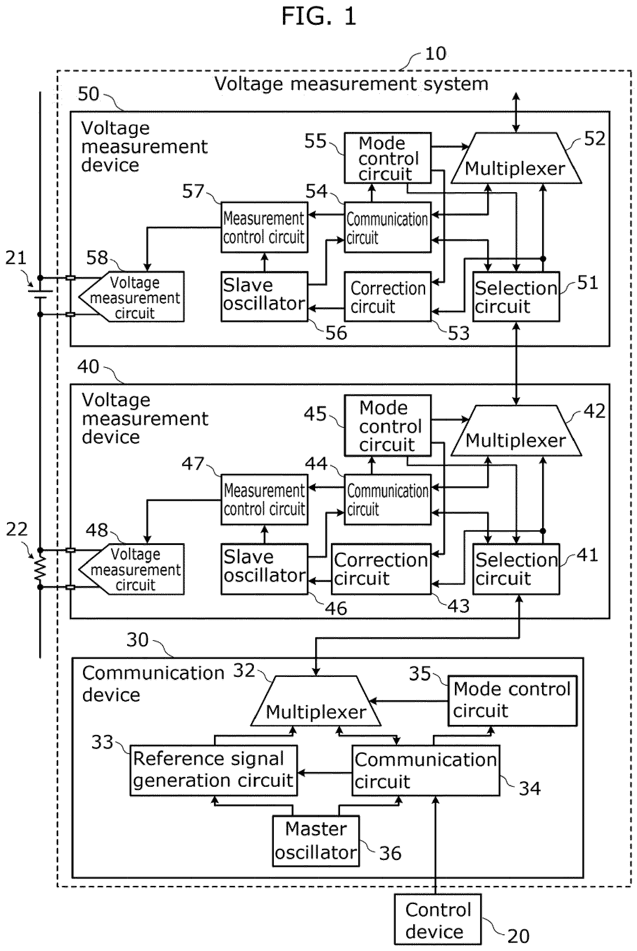

   FIG. 1 is a block diagram illustrating the functional configuration of a voltage measurement system according to Embodiment 1.
[FIG. 2]

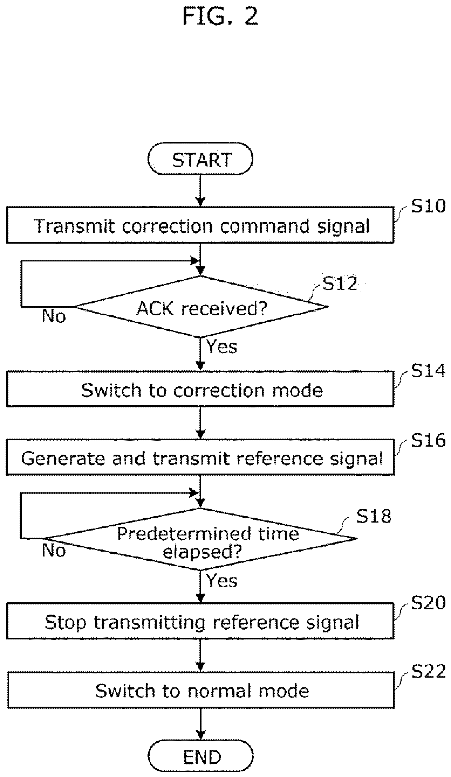

   FIG. 2 is a flowchart illustrating the flow of operations in a correction mode that are performed by a communication circuit according to Embodiment 1.
[FIG. 3]

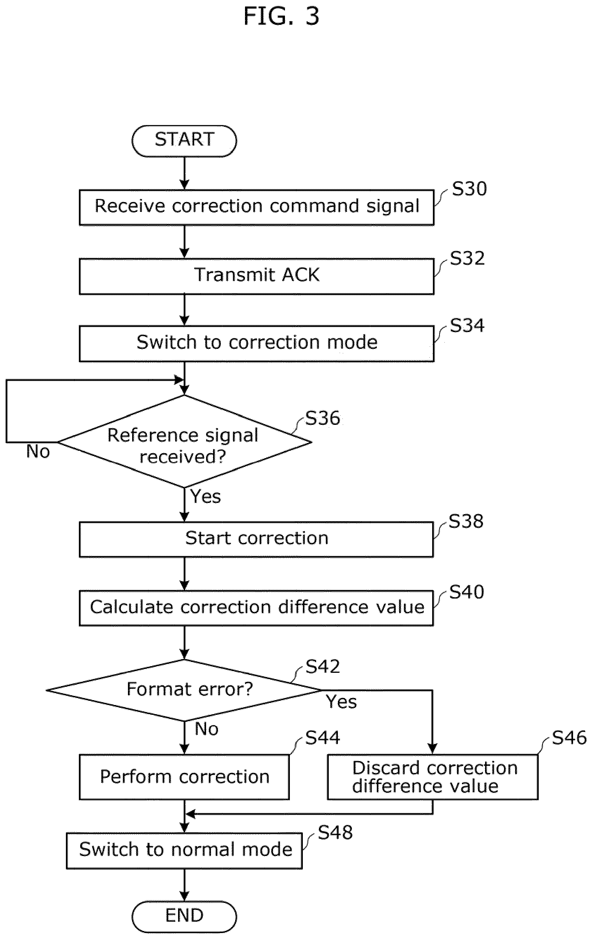

   FIG. 3 is a flowchart illustrating the flow of operations in the correction mode that are performed by a voltage measurement device according to Embodiment 1.
[FIG. 4]

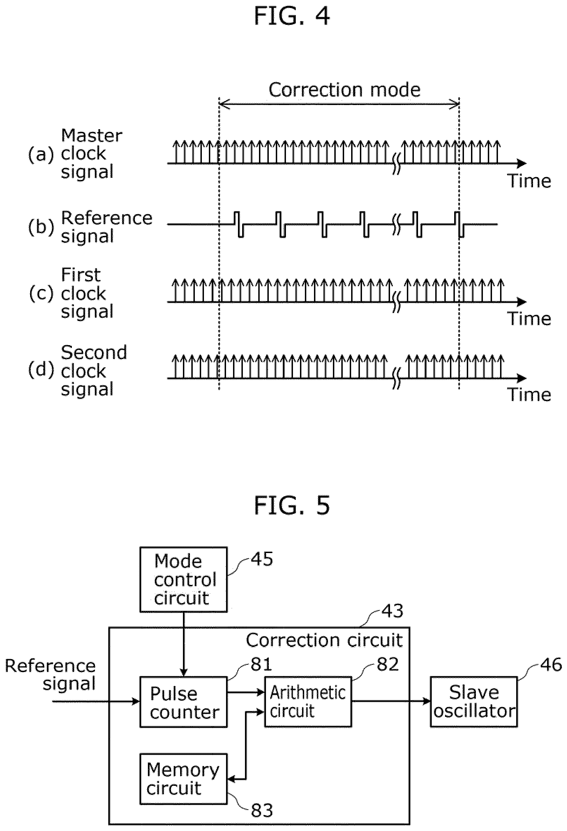

   FIG. 4 is a schematic graph illustrating one example of aspects of signals according to Embodiment 1.
[FIG. 5]
   FIG. 5 is a block diagram illustrating the functional configuration of a correction circuit according to Embodiment 1.
[FIG. 6]

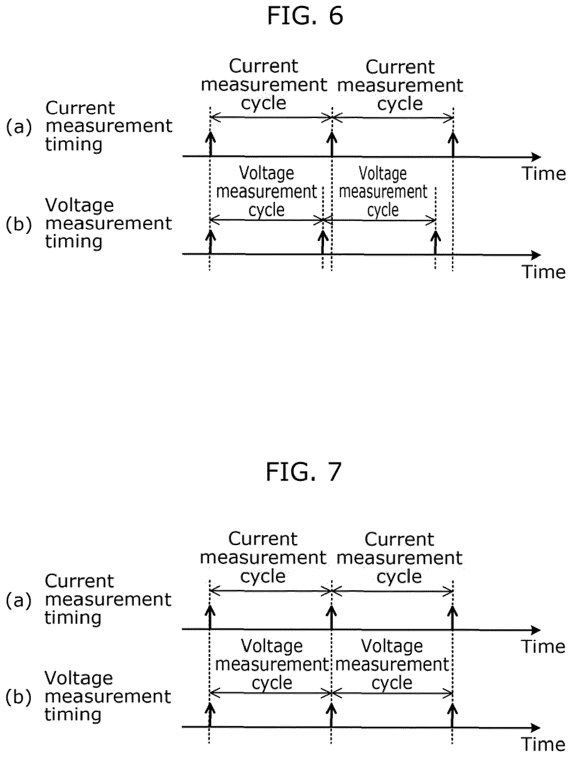

   FIG. 6 illustrates measurement timing before correction in the voltage measurement system according to Embodiment 1.
[FIG. 7]
   FIG. 7 illustrates measurement timing after correction in the voltage measurement system according to Embodiment 1.
[FIG. 8]

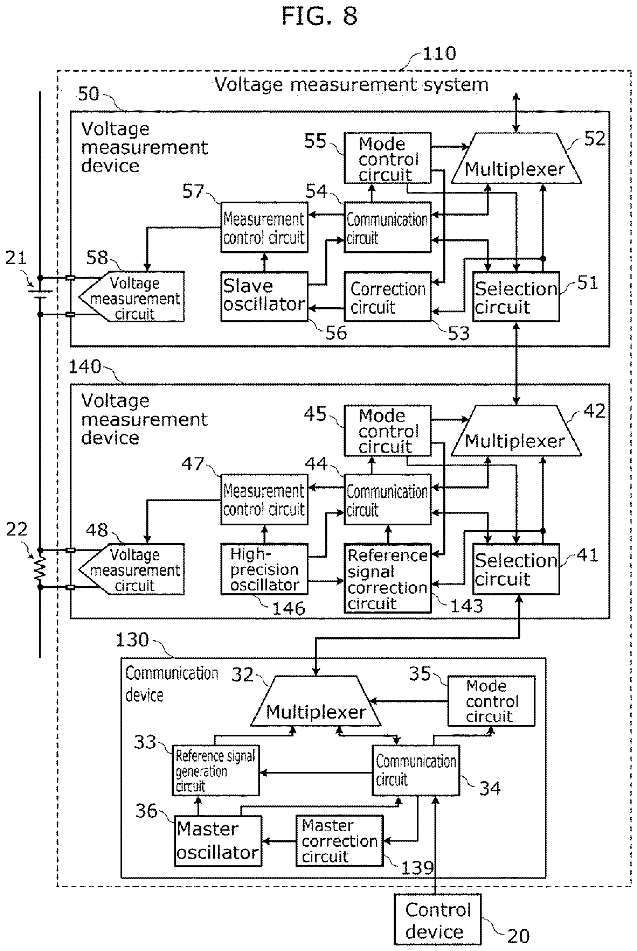

   FIG. 8 is a block diagram illustrating the functional configuration of a voltage measurement system according to Embodiment 2.
[FIG. 9]

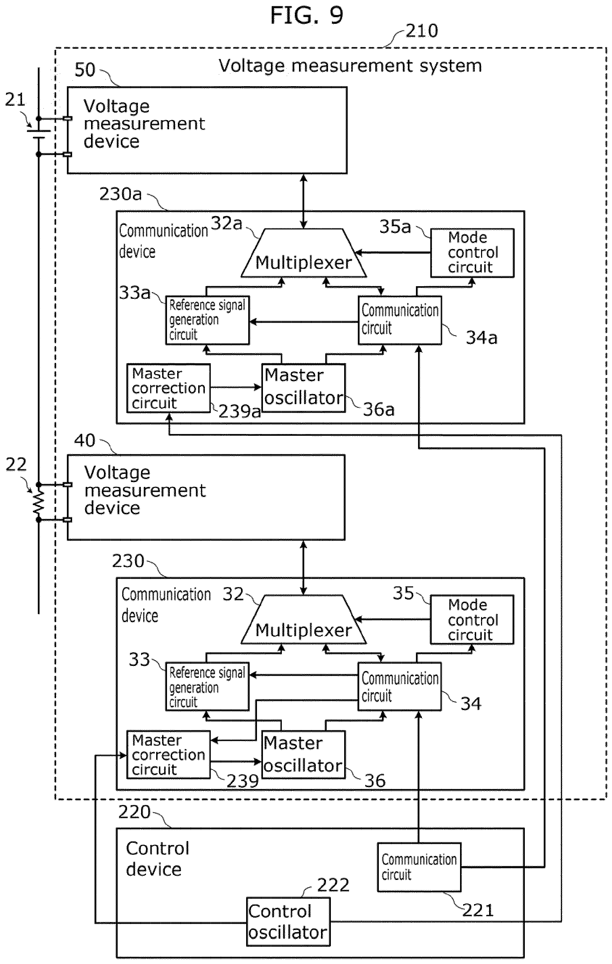

   FIG. 9 is a block diagram illustrating the functional configuration of a voltage measurement system according to Embodiment 3.
[FIG. 10]

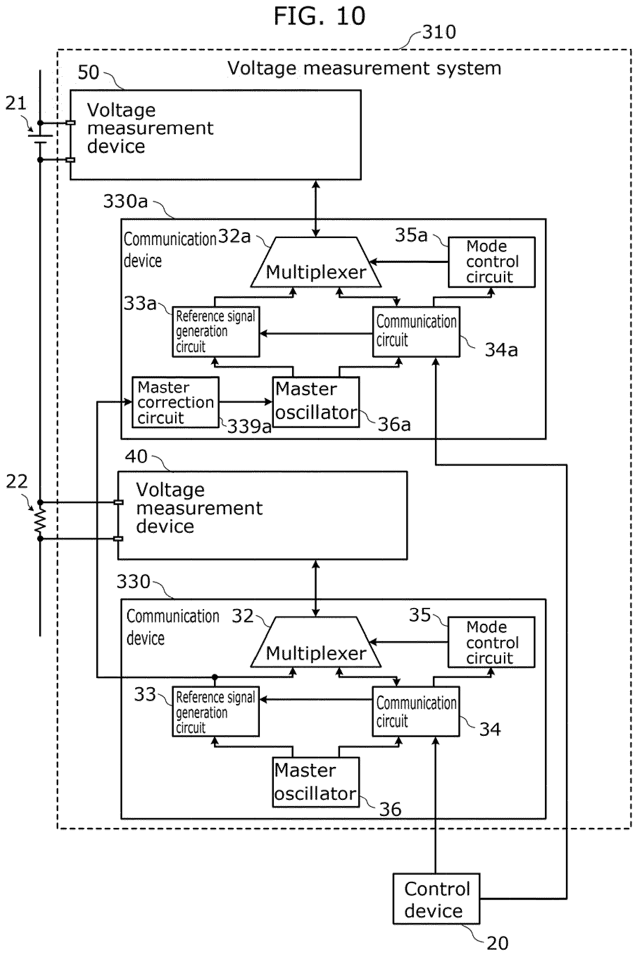

   FIG. 10 is a block diagram illustrating the functional configuration of a voltage measurement system according to Embodiment 4.
[FIG. 11]

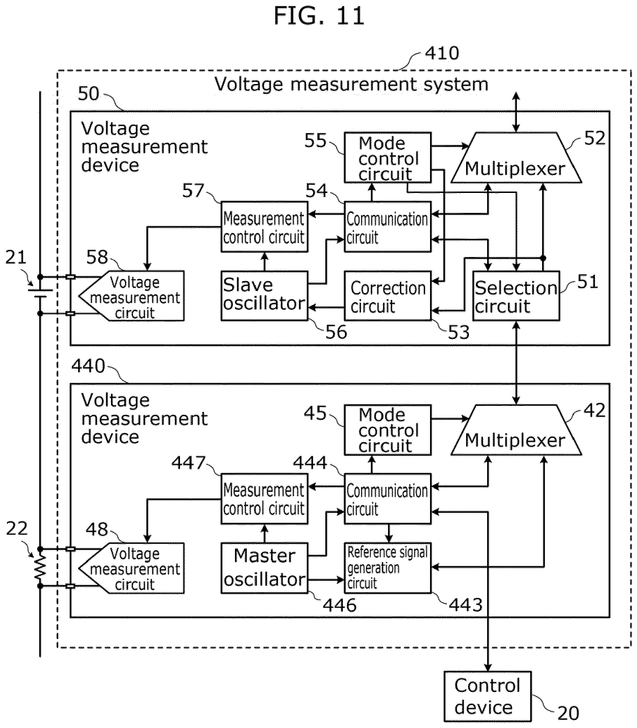

   FIG. 11 is a block diagram illustrating the functional configuration of a voltage measurement system according to Embodiment 5.
[FIG. 12]

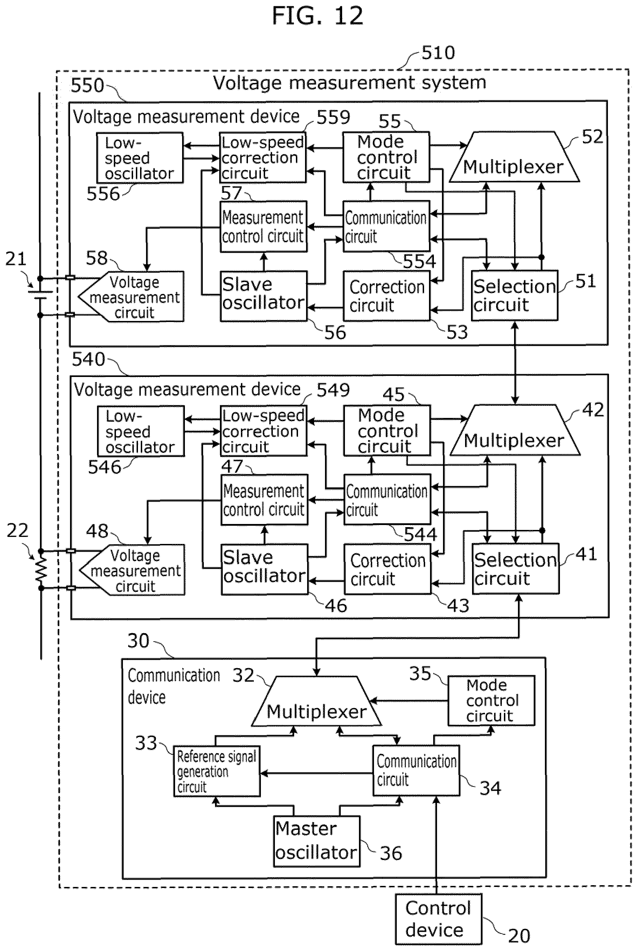

   FIG. 12 is a block diagram illustrating the functional configuration of a voltage measurement system according to Embodiment 6.

### [Description of Embodiments]

Hereinafter, embodiments of the present disclosure will be described with reference to the drawings. Each of the following embodiments shows a specific example of the present disclosure. The numerical values, shapes, materials, elements, the arrangement and connection of the elements, etc., indicated in the following embodiments are mere examples, and therefore do not intend to limit the present disclosure.

The figures are schematic illustrations and are not necessarily precise depictions. Accordingly, the figures are not necessarily to scale. Elements that are essentially the same share like reference signs in the figures, and duplicate description is omitted or simplified.

### [Embodiment 1]

The voltage measurement system according to Embodiment 1 will be described.

### [1-1. Overall Configuration]

The overall configuration of the voltage measurement system according to the present embodiment will be described with reference to FIG. 1. FIG. 1 is a block diagram illustrating the functional configuration of voltage measurement system 10 according to the present embodiment. FIG. 1 illustrates battery cell 21, which is the measurement target of voltage measurement system 10, together with resistor element 22 and control device 20 that controls voltage measurement system 10.

Control device 20 is a device that controls voltage measurement system 10. Control device 20 transmits a command signal for controlling voltage measurement system 10 to voltage measurement system 10. For example, control device 20 transmits a command signal for causing voltage measurement system 10 to start measuring voltage. Control device 20 can be realized using, for example, a micro-controller unit (MCU).

Voltage measurement system 10 measures the voltage of battery cell 21. In the present embodiment, voltage measurement system 10 also measures the current flowing in battery cell 21. Voltage measurement system 10 measures the voltage between both ends of resistor element 22 that is connected in series with battery cell 21, and from this voltage and the resistance value of resistor element 22, measures the current flowing in resistor element 22, i.e., the current flowing in battery cell 21. In the present embodiment, voltage measurement system 10 includes communication device 30 and voltage measurement devices 40 and 50. Communication device 30 and voltage measurement devices 40 and 50 transmit and receive command signals and the like using daisy communication paths. Transmission and reception of signals between communication device 30 and voltage measurement device 40 and between voltage measurement device 40 and voltage measurement device 50 may be intervened by, for example, a transformer. This allows signals to be transmitted and received while maintaining isolation between each device. Although voltage measurement system 10 is exemplified as including two voltage measurement devices 40 and 50 in the present embodiment, voltage measurement system 10 may include three or more voltage measurement devices in accordance with the number of measurement target battery cells.

Voltage measurement system 10 includes a normal mode and a correction mode. The normal mode is a mode in which the command signal is transmitted and received between communication device 30, which is one example of a first reference signal transmission device, and voltage measurement devices 40 and 50. The correction mode is a mode in which a reference signal is transmitted from communication device 30 to voltage measurement devices 40 and 50, and the oscillation frequencies of slave oscillators 46 and 56 included in voltage measurement devices 40 and 50, respectively, are synchronized with the oscillation frequency of master oscillator 36 included in communication device 30 using the reference signal.

Communication device 30 is a device that communicates with control device 20 and voltage measurement devices 40 and 50. Communication device 30 is one example of a first reference signal transmission device that transmits a reference signal for correcting the oscillation frequencies of slave oscillators 46 and 56 of voltage measurement devices 40 and 50, respectively. Communication device 30 includes communication circuit 34, master oscillator 36, reference signal generation circuit 33, mode control circuit 35, and multiplexer 32.

Communication circuit 34 is a circuit that transmits and receives the command signal to and from control device 20 and voltage measurement devices 40 and 50. When, for example, communication circuit 34 receives a command signal commanding the start of voltage measurement from control device 20, communication circuit 34 transmits the command signal (or a signal corresponding to the command signal) to voltage measurement devices 40 and 50. When communication circuit 34 receives a command signal indicating to switch to the normal mode or the correction mode from control device 20, communication circuit 34 transmits the command signal (or a signal corresponding to the command signal) to voltage measurement devices 40 and 50. When communication circuit 34 receives a command signal indicating to switch to the correction mode, communication circuit 34 transmits a signal commanding the generation of a reference signal to reference signal generation circuit 33.

Master oscillator 36 is one example of a first master oscillator that generates a master clock signal. The master clock signal is one example of a first master clock signal used to generate the reference signal. The master clock signal generated by master oscillator 36 is transmitted to reference signal generation circuit 33 and communication circuit 34.

Reference signal generation circuit 33 is one example of a first reference signal generation circuit that generates the reference signal based on the master clock signal in the correction mode. Reference signal generation circuit 33 generates the reference signal in accordance with the command signal received from communication circuit 34. The reference signal is one example of a first reference signal generated based on the master clock signal. For example, reference signal generation circuit 33 repeats the generation of one pulse every 10 clocks of master clock signal 10 times. The pulse train generated in this manner can be used as the reference signal. This makes it possible to generate a reference signal corresponding to a predetermined number of clocks in the master clock signal.

Mode control circuit 35 is a circuit that controls multiplexer 32 in accordance with the mode. Mode control circuit 35 is switched to the normal mode or the correction mode based on the command signal transmitted from communication circuit 34. Mode control circuit 35 causes multiplexer 32 to transmit the command signal in the normal mode and causes multiplexer 32 to transmit the reference signal in the correction mode.

Multiplexer 32 is a circuit that transmits and receives the command signal and the reference signal. Multiplexer 32 switches between which signal is transmitted and received based on the command signal from mode control circuit 35. Multiplexer 32 transmits and receives the command signal in the normal mode and transmits and receives the reference signal in the correction mode.

Voltage measurement device 40 is a device that measures voltage at a timing based on a first clock signal generated by slave oscillator 46. In the present embodiment, voltage measurement device 40 functions as a current measurement device that measures the current flowing in resistor element 22 and battery cell 21 by measuring the voltage between both ends of resistor element 22. Voltage measurement device 40 is one example of a first voltage measurement device that corrects the oscillation frequency of slave oscillator 46 based on the reference signal received from communication device 30. In the normal mode, voltage measurement device 40 enters the correction mode when it receives a command signal indicating to enter the correction mode from communication device 30. Voltage measurement device 40 includes selection circuit 41, multiplexer 42, correction circuit 43, communication circuit 44, mode control circuit 45, slave oscillator 46, measurement control circuit 47, and voltage measurement circuit 48.

Selection circuit 41 is one example of a first selection circuit that transmits and receives the command signal and the reference signal. Selection circuit 41 switches between which signal is transmitted and received based on the command signal from mode control circuit 45. Selection circuit 41 transmits and receives the command signal to and from communication device 30 in the normal mode, and receives the reference signal and transmits the reference signal to correction circuit 43 and multiplexer 42 in the correction mode.

Multiplexer 42 is one example of a first multiplexer that transmits and receives the command signal and the reference signal. Multiplexer 42 switches between which signal is transmitted and received based on the command signal from mode control circuit 45. Multiplexer 42 transmits and receives the command signal in the normal mode and transmits and receives the reference signal in the correction mode. In the correction mode, multiplexer 42 transmits the reference signal to other elements in voltage measurement system 10. In the present embodiment, multiplexer 42 transmits the reference signal to voltage measurement device 50.

Correction circuit 43 is one example of a first correction circuit that corrects the oscillation frequency of slave oscillator 46 based on the reference signal. In the correction mode, correction circuit 43 receives the reference signal from selection circuit 41. The reference signal is, for example, a signal indicating the time corresponding to a predetermined number of master clock signal sequences. Correction circuit 43 corrects the oscillation frequency of slave oscillator 46 so that the predetermined number of first clock signal sequences are included within the time indicated by the reference signal. The correction method used by correction circuit 43 will be described later.

Communication circuit 44 is one example of a first communication circuit that transmits and receives the command signal to and from communication device 30 and voltage measurement device 50. For example, when communication circuit 44 receives a command signal commanding the start of voltage measurement from communication device 30 via selection circuit 41, communication circuit 44 transmits the command signal (or a signal corresponding to the command signal) to measurement control circuit 47 and voltage measurement device 50. When communication circuit 44 receives a command signal indicating to switch to the normal mode or the correction mode from communication device 30, communication circuit 44 transmits the command signal (or a signal corresponding to the command signal) to mode control circuit 45 and voltage measurement device 50.

Mode control circuit 45 is one example of a first mode control circuit that controls multiplexer 42 and selection circuit 41 in accordance with the mode. Mode control circuit 45 also has the function of causing correction circuit 43 to start correction. Mode control circuit 45 is switched to the normal mode or the correction mode based on the command signal transmitted from communication circuit 44. Mode control circuit 45 causes multiplexer 42 and selection circuit 41 to transmit the command signal in the normal mode and causes multiplexer 42 and selection circuit 41 to transmit the reference signal in the correction mode.

Slave oscillator 46 is one example of a first slave oscillator that generates a first clock signal. The first clock signal generated by slave oscillator 46 is transmitted to correction circuit 43, communication circuit 44, and measurement control circuit 47.

Measurement control circuit 47 is one example of a first measurement control circuit that controls voltage measurement circuit 48 based on the first clock signal. For example, measurement control circuit 47 causes voltage measurement circuit 48 to measure voltage in a cycle determined based on the first clock signal.

Voltage measurement circuit 48 is one example of a first voltage measurement circuit that measures voltage between two terminals. In the present embodiment, voltage measurement circuit 48 measures the voltage between both ends of resistor element 22. Voltage measurement circuit 48 includes, for example, an analog-to-digital converter (ADC), converts analog measurement values into digital signals, and outputs the digital signals.

Voltage measurement device 50 is a device that measures voltage at a timing based on a second clock signal generated by slave oscillator 56. In the present embodiment, voltage measurement device 50 measures the voltage between both ends of battery cell 21. Voltage measurement device 50 is one example of a second voltage measurement device that corrects the oscillation frequency of slave oscillator 56 based on the reference signal received from communication device 30 via voltage measurement device 40. In the normal mode, voltage measurement device 50 enters the correction mode when it receives (via voltage measurement device 40) a command signal indicating to enter the correction mode from communication device 30. Voltage measurement device 50 has the same configuration as voltage measurement device 40. Voltage measurement device 50 includes selection circuit 51, multiplexer 52, correction circuit 53, communication circuit 54, mode control circuit 55, slave oscillator 56, measurement control circuit 57, and voltage measurement circuit 58.

Selection circuit 51 is one example of a second selection circuit that transmits and receives the command signal and the reference signal. Selection circuit 51 switches between which signal is transmitted and received based on the command signal from mode control circuit 55. Selection circuit 51 transmits and receives the command signal to and from voltage measurement device 40 in the normal mode, and transmits and receives the reference signal and transmits the reference signal to correction circuit 53 and multiplexer 52 in the correction mode.

Multiplexer 52 is one example of a second multiplexer that transmits and receives the command signal and the reference signal. Multiplexer 52 switches between which signal is transmitted and received based on the command signal from mode control circuit 55. Multiplexer 52 transmits and receives the command signal in the normal mode and transmits and receives the reference signal in the correction mode.

Correction circuit 53 is one example of a second correction circuit that corrects the oscillation frequency of slave oscillator 56 based on the reference signal. In the correction mode, correction circuit 53 receives the reference signal from selection circuit 51. The reference signal is, for example, a signal indicating the time corresponding to a predetermined number of master clock signal sequences. Correction circuit 53 corrects the oscillation frequency of slave oscillator 56 so that the predetermined number of second clock signal sequences are included within the time indicated by the reference signal.

Communication circuit 54 is one example of a first communication circuit that transmits and receives the command signal to and from communication device 30 and voltage measurement device 40. For example, when communication circuit 54 receives a command signal commanding the start of voltage measurement from voltage measurement device 40 via selection circuit 51, communication circuit 54 transmits the command signal (or a signal corresponding to the command signal) to measurement control circuit 57. When communication circuit 54 receives a command signal indicating to switch to the normal mode or the correction mode from voltage measurement device 40, communication circuit 54 transmits the command signal (or a signal corresponding to the command signal) to mode control circuit 55.

Mode control circuit 55 is one example of a second mode control circuit that controls multiplexer 52 and selection circuit 51 in accordance with the mode. Mode control circuit 55 also has the function of causing correction circuit 53 to start correction. Mode control circuit 55 is switched to the normal mode or the correction mode based on the command signal transmitted from communication circuit 54. Mode control circuit 55 causes multiplexer 52 and selection circuit 51 to transmit the command signal in the normal mode and causes multiplexer 52 and selection circuit 51 to transmit the reference signal in the correction mode.

Slave oscillator 56 is one example of a second slave oscillator that generates a second clock signal. The second clock signal generated by slave oscillator 56 is transmitted to correction circuit 53, communication circuit 54, and measurement control circuit 57.

Measurement control circuit 57 is one example of a second measurement control circuit that controls voltage measurement circuit 58 based on the second clock signal. For example, measurement control circuit 57 causes voltage measurement circuit 58 to measure voltage in a cycle determined based on the second clock signal.

Voltage measurement circuit 58 is one example of a second voltage measurement circuit that measures voltage between two terminals. In the present embodiment, voltage measurement circuit 58 measures the voltage between both ends of battery cell 21. Voltage measurement circuit 58 includes, for example, an ADC, which converts analog measurement values into digital signals for output.

### [1-2. Correction Method]

The method of correcting the oscillation frequencies of slave oscillators 46 and 56 according to the present embodiment will be described with reference to FIG. 2 through FIG. 4. FIG. 2 is a flowchart illustrating the flow of operations in the correction mode that are performed by communication device 30 according to the present embodiment. FIG. 3 is a flowchart illustrating the flow of operations in the correction mode that are performed voltage measurement device 40 according to the present embodiment. FIG. 4 is a schematic graph illustrating one example of aspects of signals according to the present embodiment. Graphs (a), (c), and (d) in FIG. 4 show the output timing of the master clock signal, the first clock signal, and the second clock signal, respectively. Graph (b) in FIG. 4 shows the time waveform of the reference signal.

First, operations in communication device 30 will be explained with reference to FIG. 2 and FIG. 4.

As illustrated in FIG. 2, communication device 30 transmits a correction command signal, which is a command signal indicating to switch to the correction mode, to voltage measurement device 40 (and voltage measurement device 50) (S10).

Next, communication device 30 determines whether it has received an ACK from voltage measurement device 40 and voltage measurement device 50 (S12). An ACK is a signal transmitted by each of voltage measurement devices 40 and 50 upon receiving the correction command signal.

If communication device 30 has not received an ACK (No in S12), step S12 is repeated.

If communication device 30 does receive an ACK (Yes in S12), it switches to the correction mode (S14). More specifically, when communication circuit 34 receives an ACK, it transmits a command signal to mode control circuit 35 that commands switching to the correction mode.

Next, communication device 30 generates a reference signal and transmits it to voltage measurement device 40 (and voltage measurement device 50) (S16). More specifically, communication circuit 34 transmits a command signal to reference signal generation circuit 33 that commands reference signal generation circuit 33 to start generating a reference signal. Reference signal generation circuit 33 generates the reference signal based on the master clock signal from master oscillator 36. As illustrated in graph (a) in FIG. 4, the master clock signal is a signal that is constantly output repeatedly at a predetermined oscillation frequency. However, the configuration of the reference signal is not limited to this example. In the present embodiment, reference signal generation circuit 33 repeats, a predetermined number of times, generating one pulse signal every time a predetermined number of master clock signals are output. A pulse signal sequence generated in this manner, as illustrated in graph (b) in FIG. 4, may be used as the reference signal. For example, if reference signal includes 21 pulse signals generated for every five master clock signals output, the period from the first pulse signal to the last pulse signal in the reference signal corresponds to a period equivalent to the output of 100 master clock signals.

Next, communication device 30 determines whether a predetermined time has elapsed (S18). If the predetermined time has not elapsed (No in S18), the reference signal continues to be transmitted. In the present embodiment, the reference signal continues to be transmitted for a time equivalent to the time from the start to the end of the transmission of a predetermined number of pulse signals generated by reference signal generation circuit 33.

Next, when the predetermined time has elapsed (Yes in S18), communication device 30 stops transmitting the reference signal (S20) and switches to the normal mode (S22). More specifically, communication circuit 34 transmits a command signal to mode control circuit 35 that commands switching to the normal mode. Communication circuit 34 also transmits a command signal to reference signal generation circuit 33 that commands reference signal generation circuit 33 to stop generating the reference signal.

Next, operations in voltage measurement device 40 will be explained with reference to FIG. 3 and FIG. 4.

Voltage measurement device 40 receives a correction command signal from communication device 30 (S30). More specifically, communication circuit 44 receives the correction command signal via selection circuit 41.

Next, voltage measurement device 40 transmits an ACK to communication device 30 (S32). More specifically, communication circuit 44 transmits an ACK to communication device 30 via selection circuit 41.

Next, voltage measurement device 40 switches to the correction mode (S34). More specifically, after transmitting an ACK, communication circuit 44 transmits a command signal to mode control circuit 45 that commands switching to the correction mode.

Next, voltage measurement device 40 determines whether it has received a reference signal (S36). If voltage measurement device 40 has not received a reference signal (No in S36), step S36 is repeated.

If voltage measurement device 40 has received a reference signal (Yes in S36), the correction is started (S38). The correction method in correction circuit 43 according to the present embodiment will be described with reference to FIG. 5.

FIG. 5 is a block diagram illustrating the functional configuration of correction circuit 43 according to the present embodiment. FIG. 5 also illustrates mode control circuit 45 and slave oscillator 46. As illustrated in FIG. 5, correction circuit 43 includes pulse counter 81, arithmetic circuit 82, and memory circuit 83.

Pulse counter 81 is a circuit that receives an input of a reference signal and counts the number of pulse signals included in the reference signal. Pulse counter 81 outputs the counted number of pulse signals to arithmetic circuit 82.

Arithmetic circuit 82 is a circuit that calculates a correction difference value based on the number of pulse signals in the reference signal and information corresponding to the oscillation frequency of slave oscillator 46 before correction. Arithmetic circuit 82 corrects the oscillation frequency of slave oscillator 46 by outputting a signal corresponding to the correction difference value to slave oscillator 46.

Memory circuit 83 is a circuit that stores information corresponding to the oscillation frequency of slave oscillator 46 before correction. Memory circuit 83 stores the "trimming value" corresponding to the oscillation frequency of slave oscillator 46 before correction. The trimming value is the correction value used to set the oscillation frequency of slave oscillator 46 before correction.

When starting correction in correction circuit 43, a signal from mode control circuit 45 starts the counting of the pulse signals included in the reference signal by pulse counter 81. Pulse counter 81 outputs the counted number of pulse signals to arithmetic circuit 82.

Next, as illustrated in FIG. 3, voltage measurement device 40 calculates the correction difference value (S40). In the present embodiment, arithmetic circuit 82 illustrated in FIG. 5 calculates the correction difference value from the number of pulse signals in the reference signal and information corresponding to the oscillation frequency of slave oscillator 46 before correction.

More specifically, arithmetic circuit 82 calculates, from the number of pulse signals included in the reference signal, the period corresponding to the reference signal and the number of master clock signals output from master oscillator 36 during that period. For example, arithmetic circuit 82 may store in advance the number of outputs of the master clock signal per which the pulse signals included in the reference signal are generated. This allows arithmetic circuit 82 to calculate the number of master clock signals output from master oscillator 36 during the period corresponding to the reference signal, based on the number of pulse signals included in the reference signal.

Arithmetic circuit 82 further calculates the number of first clock signals output from slave oscillator 46 during the period corresponding to the reference signal, from information corresponding to the oscillation frequency of slave oscillator 46 before correction that is input from memory circuit 83 (see graph (c) in FIG. 4).

Arithmetic circuit 82 calculates the correction difference value by calculating the difference between the number of master clock signals output from master oscillator 36 and the number of first clock signals output from slave oscillator 46 within the period corresponding to the reference signal, as described above.

Next, as illustrated in FIG. 3, voltage measurement device 40 determines whether there is a format error in the reference signal (S42). For example, if the reference signal is not a pulse signal sequence like that illustrated in graph (b) in FIG. 4, or if the number of pulse signals counted is not in a predetermined range, arithmetic circuit 82 of correction circuit 43 determines that there is a format error in the reference signal.

If voltage measurement device 40 determines that there is a format error in the reference signal (Yes in S42), the calculated correction difference value is discarded and no correction is performed (S46). However, if voltage measurement device 40 determines that there is no format error in the reference signal (No in S42), it performs a correction using the calculated correction difference value (S44). In the present embodiment, arithmetic circuit 82 illustrated in FIG. 5 corrects the oscillation frequency of slave oscillator 46 by transmitting a signal corresponding to the correction difference value to slave oscillator 46. For example, the oscillation frequency of slave oscillator 46 can be corrected by adjusting the time constant of the circuitry in slave oscillator 46. More specifically, the time constant of the RC circuit included in slave oscillator 46 can be adjusted by adjusting the resistive component in the RC circuit. This makes it possible to correct the oscillation frequency of slave oscillator 46. In memory circuit 83, the trimming value before correction is rewritten to the trimming value corresponding to the correction difference value used for correction.

Next, voltage measurement device 40 switches from the correction mode to the normal mode (S48). More specifically, communication circuit 44 transmits a command signal to mode control circuit 45 that commands switching to the normal mode.

As described above, correction circuit 43 of voltage measurement device 40 counts the number of pulse signals in the reference signal and corrects the oscillation frequency of slave oscillator 46 based on the number. Correction circuit 43 corrects the oscillation frequency of slave oscillator 46 based on a correction difference value calculated from (i) the number of clocks of master oscillator 36 corresponding to the number of pulse signals and (ii) the number of clocks of slave oscillator 46 in the period corresponding to the reference signal. Note that the oscillation frequency of slave oscillator 56 of voltage measurement device 50 can be corrected in the same way.

### [1-3. Advantageous Effects]

The advantageous effects of voltage measurement system 10 according to the present embodiment will be described with reference to FIG. 4, FIG. 6, and FIG. 7. FIG. 6 illustrates measurement timing before correction in voltage measurement system 10 according to the present embodiment, and FIG. 7 illustrates measurement timing after correction in voltage measurement system 10 according to the present embodiment.

Graphs (a) in FIG. 6 and FIG. 7, which show the current measurement timing, correspond to the timing of voltage measurement by voltage measurement device 40, i.e., the timing of measurement of the current flowing in battery cell 21. Graphs (b) in FIG. 6 and FIG. 7, which show the voltage measurement timing, correspond to the timing of measurement of the voltage of battery cell 21 by voltage measurement device 40. The positions of the upward arrows in FIG. 6 and FIG. 7 indicate measurement timing.

As mentioned above, in the present embodiment, voltage measurement device 40 measures voltage in a cycle determined based on the first clock signal output by slave oscillator 46, and voltage measurement device 50 measures voltage in a cycle determined based on the second clock signal output by slave oscillator 56. For example, the voltage is measured every time each of the first clock signal and the second clock signal is output for 1000 clocks.

Accordingly, if the oscillation frequency of slave oscillator 46 does not match the oscillation frequency of slave oscillator 56, as illustrated in graph (c) and graph (d) in FIG. 4, the current measurement cycle and the voltage measurement cycle are different, as illustrated in FIG. 6. Therefore, even if the current measurement timing and the voltage measurement timing are approximately the same at the start of measurement, the timing deviation between them gradually increases. The state of the battery cell therefore cannot be determined with high precision.

However, by matching the oscillation frequency of slave oscillator 46 and slave oscillator 56 to the oscillation frequency of master oscillator 36 via correction, the measurement timing of each voltage measurement device can be controlled with high precision. In such cases, as illustrated in FIG. 7, the current measurement cycle and the voltage measurement cycle can be matched. This makes it possible to make the current measurement timing and the voltage measurement timing approximately the same. Accordingly, the state of the battery cell can be determined with high precision.

Furthermore, since voltage measurement system 10 according to the present embodiment uses a daisy communication path to transmit and receive not only the command signal but also the reference signal, there is no need to provide a new communication path for transmitting and receiving the reference signal. In addition, since using a daisy communication path makes it possible to perform correction for each voltage measurement device simultaneously and in parallel with a single command output from communication device 30, correction can be performed simply and quickly. Since voltage measurement system 10 according to the present embodiment includes a normal mode and a correction mode, and the command signal or the reference signal is transmitted and received in accordance with each mode, collision between these signals can be avoided.

### [Embodiment 2]

The voltage measurement system according to Embodiment 2 will be described. The voltage measurement system according to the present embodiment differs from voltage measurement system 10 according to Embodiment 1 in that the voltage measurement device includes a high-precision oscillator and the oscillation frequency of the master oscillator is corrected in accordance with the high-precision oscillator. The voltage measurement system according to the present embodiment will be described, focusing on the differences from voltage measurement system 10 according to Embodiment 1.

### [2-1. Overall Configuration]

The overall configuration of the voltage measurement system according to the present embodiment will be described with reference to FIG. 8. FIG. 8 is a block diagram illustrating the functional configuration of voltage measurement system 110 according to the present embodiment. FIG. 8 illustrates battery cell 21, which is the measurement target of voltage measurement system 110, together with resistor element 22 and control device 20 that controls voltage measurement system 110.

As illustrated in FIG. 8, voltage measurement system 110 includes communication device 130 and voltage measurement devices 140 and 50.

Voltage measurement device 140 according to the present embodiment includes selection circuit 41, multiplexer 42, reference signal correction circuit 143, communication circuit 44, mode control circuit 45, high-precision oscillator 146, measurement control circuit 47, and voltage measurement circuit 48.

High-precision oscillator 146 is an oscillator that generates a high-precision clock signal that is more precise than master oscillator 36. The high-precision clock signal generated by high-precision oscillator 146 is transmitted to reference signal correction circuit 143, communication circuit 44, and measurement control circuit 47. Note that high-precision oscillator 146 need not be included as an element of voltage measurement device 140. For example, high-precision oscillator 146 may transmit a clock signal to voltage measurement device 140 from outside voltage measurement device 140.

Reference signal correction circuit 143 is a circuit that calculates a correction difference value for correcting the reference signal. Reference signal correction circuit 143 calculates a correction difference value between the high-precision clock signal and the master clock signal, similar to correction circuit 43 according to Embodiment 1. Reference signal correction circuit 143 transmits the calculated correction difference value to communication device 130 via communication circuit 34 and selection circuit 41.

Communication device 130 includes communication circuit 34, master oscillator 36, reference signal generation circuit 33, mode control circuit 35, multiplexer 32, and master correction circuit 139.

Master correction circuit 139 is a circuit that corrects the oscillation frequency of master oscillator 36 based on the high-precision clock signal. The oscillation frequency of master oscillator 36 is corrected by outputting to master oscillator 36 a signal corresponding to the correction difference value calculated by reference signal correction circuit 143 of voltage measurement device 140. The correction of the oscillation frequency of master oscillator 36 can be performed in the same way as the correction of the oscillation frequency of slave oscillator 46 according to Embodiment 1.

### [2-2. Correction Method]

The method of correcting the oscillation frequency of master oscillator 36 and slave oscillator 56 in voltage measurement system 110 according to the present embodiment will be described.

First, master oscillator 36 is corrected. More specifically, as in the correction method according to Embodiment 1, communication device 130 switches to the correction mode and transmits a reference signal.

Next, reference signal correction circuit 143 of voltage measurement device 140 calculates the correction difference value and transmits it to communication circuit 44, just like in the correction method according to Embodiment 1.

Next, communication circuit 44 of voltage measurement device 140 transmits a signal corresponding to the correction difference value to communication device 130 via selection circuit 41.

Next, communication circuit 34 of communication device 130 receives the signal corresponding to the correction difference value via multiplexer 32, and transmits it to master correction circuit 139.

Next, master correction circuit 139 corrects the oscillation frequency of master oscillator 36 by outputting the signal corresponding to the correction difference value to master oscillator 36.

As described above, the oscillation frequency of master oscillator 36 can be corrected to match the oscillation frequency of high-precision oscillator 146.

Thereafter, the oscillation frequency of slave oscillator 56 is corrected in the same manner as Embodiment 1.

This makes it possible to match the oscillation frequency of slave oscillator 56 to the oscillation frequency of high-precision oscillator 146. Therefore, the same effects as in voltage measurement system 10 according to Embodiment 1 are achieved in voltage measurement system 110 according to the present embodiment as well. Moreover, since the present embodiment can correct the oscillation frequency of master oscillator 36, the measurement timing of each voltage measurement device can be controlled with even higher precision.

### [Embodiment 3]

The voltage measurement system according to Embodiment 3 will be described. The voltage measurement system according to the present embodiment differs from voltage measurement system 10 according to Embodiment 1 mainly in that it includes two communication devices. The voltage measurement system according to the present embodiment will be described, focusing on the differences from voltage measurement system 10 according to Embodiment 1.

### [3-1. Overall Configuration]

The overall configuration of the voltage measurement system according to the present embodiment will be described with reference to FIG. 9. FIG. 9 is a block diagram illustrating the functional configuration of voltage measurement system 210 according to the present embodiment. FIG. 9 illustrates battery cell 21, which is the measurement target of voltage measurement system 210, together with resistor element 22 and control device 220 that controls voltage measurement system 210.

As illustrated in FIG. 9, voltage measurement system 210 includes communication devices 230 and 230a and voltage measurement devices 40 and 50. In the present embodiment, signals are transmitted and received between control device 220, communication device 230, and voltage measurement device 40 using a daisy communication path, and signals are transmitted and received between control device 220, communication device 230a, and voltage measurement device 50 using a daisy communication path.

Control device 220 includes communication circuit 221 and control oscillator 222.

Communication circuit 221 is a circuit that transmits and receives the command signal between communication devices 230 and 230a.

Control oscillator 222 is an oscillator that generates a control clock signal.

Communication device 230 is one example of a first reference signal transmission device that receives a control clock signal, which is a clock signal input from outside, and transmits a reference signal. Communication device 230 includes communication circuit 34, master oscillator 36, reference signal generation circuit 33, mode control circuit 35, multiplexer 32, and master correction circuit 239.

Master correction circuit 239 is one example of a first master correction circuit that corrects the oscillation frequency of master oscillator 36 based on the control clock signal. A control clock signal is input to master correction circuit 239. Master correction circuit 239 may, for example, count the number of control clock signals in a predetermined time period, calculate a correction difference value from this number and the number of master clock signals in the predetermined time period of master oscillator 36, and correct the oscillation frequency of master oscillator 36 based on the calculated correction difference value.

Communication device 230a is one example of a second reference signal transmission device that receives a control clock signal, which is a clock signal input from outside, and transmits a reference signal. Communication device 230a transmits and receives the command signal to and from voltage measurement device 50, and transmits the reference signal to voltage measurement device 50. Communication device 230a includes communication circuit 34a, master oscillator 36a, reference signal generation circuit 33a, mode control circuit 35a, multiplexer 32a, and master correction circuit 239a. Communication circuit 34a, master oscillator 36a, reference signal generation circuit 33a, mode control circuit 35a, multiplexer 32a, and master correction circuit 239a have the same configurations as communication circuit 34, master oscillator 36, reference signal generation circuit 33, mode control circuit 35, multiplexer 32, and master correction circuit 239, respectively.

Master oscillator 36a is one example of a second master oscillator that generates a master clock signal. The master clock signal generated by master oscillator 36a is one example of a second master clock signal.

Reference signal generation circuit 33a is one example of a second reference signal generation circuit that generates a reference signal based on the master clock signal generated by master oscillator 36a. The reference signal generated by reference signal generation circuit 33a is one example of a second reference signal generated based on the master clock signal generated by master oscillator 36a.

Master correction circuit 239a is one example of a second master correction circuit that corrects the oscillation frequency of master oscillator 36a based on the control clock signal.

### [3-2. Correction Method]

The method of correcting the oscillation frequencies of master oscillators 36 and 36a and slave oscillators 46 and 56 in voltage measurement system 210 according to the present embodiment will be described.

First, master oscillators 36 and 36a are corrected. More specifically, communication devices 230 and 230a switch to the correction mode based on the command signal from control device 220.

Next, master correction circuit 239 calculates a correction difference value based on the control clock signal input from control device 220 using a method like that described above. Master correction circuit 239a similarly calculates a correction difference value.

Next, master correction circuit 239 corrects the oscillation frequency of master oscillator 36 by inputting a signal corresponding to the correction difference value to master oscillator 36. Master correction circuit 239a similarly corrects the oscillation frequency of master oscillator 36a.

As described above, the oscillation frequencies of master oscillators 36 and 36a can be corrected based on the control clock signal.

Thereafter, the oscillation frequencies of slave oscillators 46 and 56 are corrected in the same manner as Embodiment 1.

This makes it possible to match the oscillation frequencies of master oscillators 36 and 36a and slave oscillators 46 and 56 with the oscillation frequency of control oscillator 222. Therefore, the same effects as in voltage measurement system 10 according to Embodiment 1 are achieved in voltage measurement system 210 according to the present embodiment as well.

### [Embodiment 4]

The voltage measurement system according to Embodiment 4 will be described. The voltage measurement system according to the present embodiment differs from voltage measurement system 210 according to Embodiment 3 mainly in that the reference signal transmitted by one of the two communication devices is used to correct the oscillation frequency of the master oscillator of the other communication device. The voltage measurement system according to the present embodiment will be described, focusing on the differences from voltage measurement system 210 according to Embodiment 3.

### [4-1. Overall Configuration]

The overall configuration of the voltage measurement system according to the present embodiment will be described with reference to FIG. 10. FIG. 10 is a block diagram illustrating the functional configuration of voltage measurement system 310 according to the present embodiment. FIG. 10 illustrates battery cell 21, which is the measurement target of voltage measurement system 310, together with resistor element 22 and control device 20 that controls voltage measurement system 310.

As illustrated in FIG. 10, voltage measurement system 310 includes communication devices 330 and 330a and voltage measurement devices 40 and 50. In the present embodiment, signals are transmitted and received between control device 20, communication device 330, and voltage measurement device 40 using a daisy communication path, and signals are transmitted and received between control device 20, communication device 330a, and voltage measurement device 50 using a daisy communication path.

Communication device 330 is one example of a first reference signal transmission device that transmits a reference signal. Communication device 330 includes communication circuit 34, master oscillator 36, reference signal generation circuit 33, mode control circuit 35, and multiplexer 32. Communication device 330 according to the present embodiment differs from communication device 30 according to Embodiment 1 in that the reference signal is transmitted not only to voltage measurement device 40 but also to communication device 330a, and is identical in other respects.

Communication device 330a is one example of a second reference signal transmission device that transmits a reference signal. Communication device 330a includes communication circuit 34a, master oscillator 36a, reference signal generation circuit 33a, mode control circuit 35a, multiplexer 32a, and master correction circuit 339a.

Master correction circuit 339a is one example of a second master correction circuit that corrects the oscillation frequency of master oscillator 36a based on the master clock signal generated by master oscillator 36 of communication device 330. Master correction circuit 339a receives the reference signal from communication device 330. Master correction circuit 339a has the same configuration as correction circuit 43 according to Embodiment 1, and corrects the oscillation frequency of master oscillator 36a based on the reference signal.

### [4-2. Correction Method]

The method of correcting the oscillation frequencies of master oscillator 36a and slave oscillators 46 and 56 in voltage measurement system 310 according to the present embodiment will be described.

First, master oscillator 36a is corrected. More specifically, communication devices 330 and 330a switch to the correction mode based on the command signal from control device 20.

Next, communication device 330 transmits to master correction circuit 339a of communication device 330a a reference signal generated in the same manner as the reference signal according to Embodiment 1. Master correction circuit 339a calculates a correction difference value based on the received reference signal.

Next, master correction circuit 339a corrects the oscillation frequency of master oscillator 36a by inputting a signal corresponding to the correction difference value to master oscillator 36a.

As described above, the oscillation frequency of master oscillator 36a of communication device 330a can be corrected based on the master clock signal of master oscillator 36 included in communication device 330.

Thereafter, the oscillation frequencies of slave oscillators 46 and 56 are corrected in the same manner as Embodiment 1.

This makes it possible to match the oscillation frequencies of master oscillator 36a and slave oscillators 46 and 56 with the oscillation frequency of master oscillator 36. Therefore, the same effects as in voltage measurement system 210 according to Embodiment 3 are achieved in voltage measurement system 310 according to the present embodiment as well.

### [Embodiment 5]

The voltage measurement system according to Embodiment 5 will be described. The voltage measurement system according to the present embodiment differs from voltage measurement system 10 according to Embodiment 1 mainly in that the voltage measurement device generates the reference signal. The voltage measurement system according to the present embodiment will be described, focusing on the differences from voltage measurement system 10 according to Embodiment 1.

### [5-1. Overall Configuration]

The overall configuration of the voltage measurement system according to the present embodiment will be described with reference to FIG. 11. FIG. 11 is a block diagram illustrating the functional configuration of voltage measurement system 410 according to the present embodiment. FIG. 11 illustrates battery cell 21, which is the measurement target of voltage measurement system 410, together with resistor element 22 and control device 20 that controls voltage measurement system 410.

As illustrated in FIG. 11, voltage measurement system 410 includes voltage measurement devices 440 and 50. In the present embodiment, signals are transmitted and received between control device 20, voltage measurement device 440, and voltage measurement device 50 using a daisy communication path.

Voltage measurement device 440 is one example of a first reference signal transmission device that transmits a reference signal. Voltage measurement device 440 includes multiplexer 42, reference signal generation circuit 443, communication circuit 444, mode control circuit 45, master oscillator 446, measurement control circuit 447, and voltage measurement circuit 48.

Communication circuit 444 is a circuit that transmits and receives the command signal to and from control device 20 and voltage measurement device 50. When, for example, communication circuit 444 receives a command signal commanding the start of voltage measurement from control device 20, communication circuit 444 transmits the command signal (or a signal corresponding to the command signal) to measurement control circuit 447 and voltage measurement device 50. When communication circuit 444 receives a command signal indicating to switch to the normal mode or the correction mode from control device 20, communication circuit 444 transmits the command signal (or a signal corresponding to the command signal) to voltage measurement device 50. When communication circuit 444 receives a command signal indicating to switch to the correction mode, communication circuit 444 transmits a signal commanding the generation of a reference signal to reference signal generation circuit 443.

Master oscillator 446 is one example of a first master oscillator that generates a master clock signal. The master clock signal is one example of a first master clock signal used to generate the reference signal. The master clock signal generated by master oscillator 446 is transmitted to reference signal generation circuit 443, communication circuit 444, and measurement control circuit 447.

Reference signal generation circuit 443 is one example of a first reference signal generation circuit that generates the reference signal based on the master clock signal in the correction mode. Reference signal generation circuit 443 generates the reference signal based on the command signal received from communication circuit 444. The reference signal is one example of a first reference signal generated based on the master clock signal.

Measurement control circuit 447 is a circuit that controls voltage measurement circuit 48 based on the master clock signal. Measurement control circuit 447 has the same configuration as measurement control circuit 47 according to Embodiment 1.

Voltage measurement device 50 according to the present embodiment is one example of a first voltage measurement device that corrects the oscillation frequency of slave oscillator 56 based on the reference signal received from voltage measurement device 440.

### [5-2. Correction Method]

The method of correcting the oscillation frequency of slave oscillator 56 in voltage measurement system 410 according to the present embodiment will be described.

More specifically, voltage measurement device 440 switches to the correction mode based on the command signal from control device 20.

Next, just like communication device 30 according to Embodiment 1, reference signal generation circuit 443 of voltage measurement device 440 generates a reference signal and transmits the reference signal to voltage measurement device 50.

Next, just like voltage measurement device 50 according to Embodiment 1, voltage measurement device 50 corrects the oscillation frequency of slave oscillator 56 based on the reference signal.

This makes it possible to match the oscillation frequency of slave oscillator 56 to the oscillation frequency of master oscillator 446. Therefore, the same effects as in voltage measurement system 10 according to Embodiment 1 are achieved in voltage measurement system 410 according to the present embodiment as well. Moreover, since the communication device can be omitted in the present embodiment, the configuration can be simplified.

### [Embodiment 6]

The voltage measurement system according to Embodiment 6 will be described. The voltage measurement system according to the present embodiment differs from voltage measurement system 10 according to Embodiment 1 mainly in that the first clock signal generated by the corrected slave oscillator is used to correct the oscillator that is slower than the slave oscillator. The voltage measurement system according to the present embodiment will be described, focusing on the differences from voltage measurement system 10 according to Embodiment 1.

### [6-1. Overall Configuration]

The overall configuration of the voltage measurement system according to the present embodiment will be described with reference to FIG. 12. FIG. 12 is a block diagram illustrating the functional configuration of voltage measurement system 510 according to the present embodiment. FIG. 12 illustrates battery cell 21, which is the measurement target of voltage measurement system 510, together with resistor element 22 and control device 20 that controls voltage measurement system 510.

As illustrated in FIG. 12, voltage measurement system 510 includes communication device 30 and voltage measurement devices 540 and 550.

Voltage measurement device 540 includes selection circuit 41, multiplexer 42, correction circuit 43, communication circuit 544, mode control circuit 45, slave oscillator 46, measurement control circuit 47, voltage measurement circuit 48, low-speed correction circuit 549, and low-speed oscillator 546.

Low-speed oscillator 546 is one example of a first low-speed oscillator that generates a low-speed clock signal and oscillates at a lower oscillation frequency than slave oscillator 46. Low-speed oscillator 546 may be used to control the timing of any operation in voltage measurement device 540. For example, low-speed oscillator 546 may be used to control the timing of balancing between a plurality of battery cells.

Low-speed correction circuit 549 is one example of a first low-speed correction circuit that corrects the oscillation frequency of low-speed oscillator 546 based on the first clock signal from slave oscillator 46. For example, low-speed correction circuit 549 corrects the oscillation frequency of low-speed oscillator 546 in the correction mode. Low-speed correction circuit 549 may correct the oscillation frequency of low-speed oscillator 546 so that the number of clocks in the first clock signal output from slave oscillator 46 within a period corresponding to one pulse of the low-speed clock signal output from low-speed oscillator 546 is a predetermined number.

Low-speed correction circuit 549 may correct the oscillation frequency of low-speed oscillator 546 based on the first clock signal from slave oscillator 46 that has been corrected based on the reference signal.

Communication circuit 544 differs from communication circuit 44 according to Embodiment 1 in that it when it receives a command signal instructing correction of low-speed oscillator 546, it transmits the command signal (or a signal corresponding to the command signal) to low-speed correction circuit 549, and is identical in other respects.

Voltage measurement device 550 includes selection circuit 51, multiplexer 52, correction circuit 53, communication circuit 554, mode control circuit 55, slave oscillator 56, measurement control circuit 57, voltage measurement circuit 58, low-speed correction circuit 559, and low-speed oscillator 556. Communication circuit 554, low-speed correction circuit 559, and low-speed oscillator 556 have the same configuration, respectively, as communication circuit 544, low-speed correction circuit 549, and low-speed oscillator 546 included in voltage measurement device 540. Low-speed oscillator 556 is one example of a second low-speed oscillator that generates a low-speed clock signal and oscillates at a lower oscillation frequency than slave oscillator 56. Low-speed correction circuit 559 is one example of a second low-speed correction circuit that corrects the oscillation frequency of low-speed oscillator 556 based on the second clock signal from slave oscillator 56.

### [6-2. Correction Method]

The correction method for slave oscillators 46 and 56 and low-speed oscillators 546 and 556 according to the present embodiment will be described. The correction method for slave oscillators 46 and 56 according to the present embodiment is the same as the correction method for slave oscillators 46 and 56 according to Embodiment 1.

For example, low-speed correction circuits 549 and 559 correct low-speed oscillators 546 and 556, respectively, during the period when pulse counter 81 (see FIG. 5) counts pulses in the correction mode. This allows correction of slave oscillators 46 and 56 as well as low-speed oscillators 546 and 556.

In the correction mode, low-speed correction circuits 549 and 559 may also correct low-speed oscillators 546 and 556 after slave oscillators 46 and 56 have been corrected. This allows for high-precision control of not only the timing of voltage measurement in voltage measurement device 540, but also the timing of other operations.

### (Variations, etc.)

Although the present disclosure has been described based on the above embodiments, the present disclosure is not limited to the above embodiments.

For example, in each of the above embodiments, the control device is not included in the voltage measurement system, but the control device may be included in the voltage measurement system.

The voltage measurement system according to each of the above embodiments may be housed in, for example, a single housing, and, alternatively, may be separated into a plurality of housings.

Some or all of the elements included in the voltage measurement system according to the above embodiments may be configured in the form of a single system Large Scale Integration (LSI) chip. A system LSI chip is a super multifunctional LSI chip manufactured by integrating a plurality of elements on a single chip. More specifically, a system LSI chip is, for example, a computer system including a microprocessor, ROM, RAM, etc. The RAM stores a computer program. The functions of the system LSI chip are realized by the microprocessor operating according to the computer program.

Some or all of the elements of the voltage measurement system according to each of the above embodiments may be configured in the form of a detachable IC card or a stand-alone module. The IC card or module may be a computer system including a microprocessor, ROM, RAM, etc. The IC card or module may include the above-described super multifunctional LSI circuit. The functions of the IC card or module are realized by the microprocessor operating according to a computer program. The IC card and the module may be tamperproof.

The present disclosure may be realized as a computer system including a microprocessor and memory, the memory may store the above-described computer program, and the microprocessor may operate according to the computer program.

Various modifications of the above embodiments that may be conceived by those skilled in the art, as well as embodiments resulting from arbitrary combinations of elements and functions from different embodiments that do not depart from the essence of the present disclosure are included the present disclosure.

### [Industrial Applicability]

The voltage measurement system according to the present disclosure can be used, for example, as a voltage measurement system for an in-vehicle battery module system.

### [Reference Signs List]

10, 110, 210, 310, 410, 510 voltage measurement system
20, 220 control device
21 battery cell
22 resistor element
30, 130, 230, 230a, 330, 330a communication device
32, 32a, 42, 52 multiplexer
33, 33a, 443 reference signal generation circuit
34, 34a, 44, 54, 221, 444, 544, 554 communication circuit
35, 35a, 45, 55 mode control circuit
36, 36a, 446 master oscillator
40, 50, 140, 440, 540, 550 voltage measurement device
41, 51 selection circuit
43, 53 correction circuit
46, 56 slave oscillator
47, 57, 447 measurement control circuit
48, 58 voltage measurement circuit
81 pulse counter
82 arithmetic circuit
83 memory circuit
139, 239, 239a, 339a master correction circuit
143 reference signal correction circuit
146 high-precision oscillator
222 control oscillator
546, 556 low-speed oscillator
549, 559 low-speed correction circuit

## Claims

1. A voltage measurement system that measures a voltage of a battery cell, the voltage measurement system comprising:
a first reference signal transmission device including a first master oscillator that generates a first master clock signal and a first reference signal generation circuit that generates a first reference signal based on the first master clock signal; and
a first voltage measurement device including a first slave oscillator that generates a first clock signal, a first correction circuit that corrects an oscillation frequency of the first slave oscillator based on the first reference signal, a first voltage measurement circuit, and a first measurement control circuit that controls the first voltage measurement circuit based on the first clock signal, wherein
the voltage measurement system includes:
a normal mode in which a command signal is transmitted and received between the first reference signal transmission device and the first voltage measurement device; and
a correction mode in which the first reference signal is transmitted from the first reference signal transmission device to the first voltage measurement device, and the oscillation frequency of the first slave oscillator is synchronized with an oscillation frequency of the first master oscillator using the first reference signal.

2. The voltage measurement system according to claim 1, wherein
the first reference signal transmission device further includes:
a communication circuit that transmits and receives the command signal; and
a multiplexer that transmits and receives the command signal and the first reference signal, and
the multiplexer transmits and receives the command signal in the normal mode and transmits and receives the first reference signal in the correction mode.

3. The voltage measurement system according to claim 1 or 2, wherein
the first voltage measurement device further includes:
a first communication circuit that transmits and receives the command signal; and
a first multiplexer that transmits and receives the command signal and the first reference signal, and
the first multiplexer transmits and receives the command signal in the normal mode and transmits and receives the first reference signal in the correction mode.

4. The voltage measurement system according to claim 3, wherein
the first voltage measurement device further includes a first selection circuit that transmits and receives the command signal and the first reference signal, and
the first selection circuit transmits and receives the command signal to and from the first communication circuit in the normal mode, and receives the first reference signal and transmits the first reference signal to the first correction circuit and the first multiplexer in the correction mode.

5. The voltage measurement system according to claim 3 or 4, wherein
the first multiplexer transmits the first reference signal to an other element in the voltage measurement system in the correction mode.

6. The voltage measurement system according to any one of claims 1 to 5, wherein
the first measurement control circuit causes the first voltage measurement circuit to measure voltage in a cycle determined based on the first clock signal.

7. The voltage measurement system according to any one of claims 1 to 6, wherein
the first correction circuit counts a total number of pulse signals included in the first reference signal and corrects the oscillation frequency of the first slave oscillator based on the total number.

8. The voltage measurement system according to claim 7, wherein
the first correction circuit corrects the oscillation frequency of the first slave oscillator based on a correction difference value calculated from (i) a total number of clocks of the first master oscillator corresponding to the total number of the pulse signals and (ii) a total number of clocks of the first slave oscillator in a period corresponding to the first reference signal.

9. The voltage measurement system according to claim 7 or 8, wherein
the first correction circuit skips correction of the oscillation frequency of the first slave oscillator when the total number counted is not in a predetermined range.

10. The voltage measurement system according to any one of claims 1 to 9, wherein
the first voltage measurement device further includes:
a first low-speed oscillator that oscillates at a lower oscillation frequency than the first slave oscillator; and
a first low-speed correction circuit that corrects the oscillation frequency of the first low-speed oscillator based on the first clock signal from the first slave oscillator.

11. The voltage measurement system according to claim 10, wherein
the first low-speed correction circuit corrects the oscillation frequency of the first low-speed oscillator based on the first clock signal from the first slave oscillator corrected based on the first reference signal.

12. The voltage measurement system according to any one of claims 1 to 11, further comprising:
a second voltage measurement device that receives the first reference signal via the first voltage measurement device, wherein
the second voltage measurement device includes:
a second slave oscillator that generates a second clock signal;
a second correction circuit that corrects an oscillation frequency of the second slave oscillator based on the first reference signal;
a second voltage measurement circuit; and
a second measurement control circuit that controls the second voltage measurement circuit based on the second clock signal.

13. The voltage measurement system according to any one of claims 1 to 12, wherein
the first reference signal transmission device further includes:
a voltage measurement circuit; and
a measurement control circuit that controls the voltage measurement circuit based on the first master clock signal.

14. The voltage measurement system according to any one of claims 1 to 12, further comprising:
a high-precision oscillator that generates a high-precision clock signal that is more precise than the first master oscillator, wherein
the first reference signal transmission device further includes a first master correction circuit that corrects the oscillation frequency of the first master oscillator based on the high-precision clock signal.

15. The voltage measurement system according to any one of claims 1 to 12, further comprising:
a second reference signal transmission device including a second master oscillator that generates a second master clock signal and a second reference signal generation circuit that generates a second reference signal based on the second master clock signal, wherein
each of the first reference signal transmission device and the second reference signal transmission device receives a control clock signal that is a clock signal input from outside,
the first reference signal transmission device further includes a first master correction circuit that corrects the oscillation frequency of the first master oscillator based on the control clock signal, and
the second reference signal transmission device further includes a second master correction circuit that corrects an oscillation frequency of the second master oscillator based on the control clock signal.

16. The voltage measurement system according to any one of claims 1 to 12, further comprising:
a second reference signal transmission device including a second master oscillator that generates a second master clock signal and a second reference signal generation circuit that generates a second reference signal based on the second master clock signal, wherein
the second reference signal transmission device further includes a second master correction circuit that corrects an oscillation frequency of the second master oscillator based on the first master clock signal.
